# EUROPEAN PATENT APPLICATION

(11) **EP 4 626 150 A1**
(43) Date of publication of application: **01.10.2025**
(21) Application number: 23894901.0
(22) Date of filing: 13.11.2023
(51) Int. Cl.: H05K 1/11, H05K 1/14, H01L 23/498, G02F 1/1333, H05K 1/18

(54) **FLEXIBLE CIRCUIT BOARD, COF MODULE, AND ELECTRONIC DEVICE INCLUDING SAME**

(30) Priority: 25.11.2022 KR 20220160292; 30.12.2022 KR 20220190768
(71) Applicant: LG INNOTEK CO. LTD, Gangseo-gu Seoul 07796 (KR)
(72) Inventor: CHAE, Sung Min, Seoul 07796 (KR); JEON, Se Mi Na, Seoul 07796 (KR); PARK, Ji Hyo, Seoul 07796 (KR); LIM, Jun Young, Seoul 07796 (KR)
(74) Representative: DREISS Patentanwälte PartG mbB
(86) International application number: PCT/KR2023/018145
(87) International publication number: WO 2024/111972

(57) **Abstract**

A flexible circuit board according to an embodiment includes a substrate including a first surface and a second surface opposite to the first surface; a first circuit pattern disposed on the first surface; a second circuit pattern disposed on the first surface and the second surface; and a third circuit pattern disposed on the first surface and the second surface, wherein the second circuit pattern includes a first via and a second wiring part, wherein the third circuit pattern includes a second via and a third wiring part, wherein the first via and the second via includes a via land and a via hole formed in the via land, wherein at least one of the first via and the second via is defined as a first spacing between the via lands; a second spacing between the via land and the second wiring part or the third wiring part adjacent to the via land and a third spacing between a side surface of the via land and the via hole, and wherein at least one of the first spacing, the second spacing and the third spacing is greater than a width of the wiring part.

## Description

### [Technical Field]

An embodiment relates to a flexible circuit board, COF module, and electronic device including same.

### [Background Art]

Recently, various electronic products are becoming thinner, smaller, and lighter. Accordingly, various studies are being conducted to mount semiconductor chips in a narrow region of electronic products at high density.

COF (Chip On Film) includes a flexible substrate. Accordingly, the COF can be applied to a flexible display. For example, the COF can be applied to various wearable electronic devices. In addition, the COF method can implement a fine pitch, and accordingly, a high-resolution display can be implemented due to an increase in a number of pixels.

The COF is a method of mounting a semiconductor chip on a flexible circuit board in a form of a thin film. For example, the semiconductor chip can be an integrated circuit (IC) chip or a large scale integrated circuit (LSI) chip.

The chip can be connected to an external circuit board and a display panel through a circuit pattern. For example, a pad part is disposed on one end and another end of the circuit pattern, respectively. one pad part is electrically connected to a terminal of the chip. In addition, another pad part may be connected to terminals of the circuit board and the display panel. Accordingly, the chip, the circuit board, and the display panel are electrically connected through the COF. Accordingly, a signal may be transmitted to the display panel through the circuit pattern.

The flexible circuit board includes a plurality of circuit patterns. The circuit patterns connect the chip, the circuit board, and the display panel. A signal may be transferred to the chip, the circuit board, and the display panel through the circuit patterns.

The circuit patterns may be disposed on one surface or both surfaces of the substrate. When the circuit patterns are disposed on both surfaces of the substrate, the circuit patterns on both surfaces are connected through vias.

If an alignment of the via is misaligned, the circuit patterns on both surfaces of the substrate may be short-circuited. As a result, reliability of the flexible circuit board may be reduced.

Therefore, a flexible circuit board with a new structure capable of solving the above-mentioned problems, a COF module, and an electronic device including the same are required.

### [Disclosure]

### [Technical Problem]

An embodiment provides a flexible circuit board, a COF module and an electronic device including the same having improved reliability.

### [Technical Solution]

A flexible circuit board according to an embodiment comprises a substrate including a first surface and a second surface opposite to the first surface; a first circuit pattern disposed on the first surface; a second circuit pattern disposed on the first surface and the second surface; and a third circuit pattern disposed on the first surface and the second surface, wherein the second circuit pattern includes a first via and a second wiring part, wherein the third circuit pattern includes a second via and a third wiring part, wherein the first via and the second via includes a via land and a via hole formed in the via land, wherein at least one of the first via and the second via is defined as a first spacing between the via lands; a second spacing between the via land and the second wiring part or the third wiring part adjacent to the via land and a third spacing between a side surface of the via land and the via hole, and wherein at least one of the first spacing, the second spacing and the third spacing is greater than a width of the wiring part.

### [Advantageous Effects]

A flexible circuit board according to an embodiment includes a via. Circuit patterns on a first surface and a second surface are connected by the via. The via is disposed on the first surface and the second surface, respectively. The via includes a plurality of via lands and via holes inside the via lands.

The via lands are spaced apart by a set range of spacing. In addition, the via land is spaced apart from a wiring part of the circuit pattern by a set range of spacing. In addition, the via land and the via hole are spaced apart by a set range of spacing.

Accordingly, the via hole inside the via land is not misaligned. Accordingly, an alignment of the vias on the first surface and the second surface is not misaligned.

Accordingly, electrical connection characteristics of the flexible circuit board are improved.

The via land includes a plurality of corners. At least one corners includes a curved surface. A spacing of the via lands on which the curved surface is formed is wider than other spacings. In addition, a spacing between the wiring part and the via land on which the curved surface is formed is formed is wider than other spacings.

Accordingly, when patterning the via land and the wiring part, adjacent via lands are prevented from being connected. In addition, adjacent via lands and the wiring part are prevented from being connected.

Therefore, the reliability of the flexible circuit board is improved.

### [Description of Drawings]

FIG. 1 is a top view of a flexible circuit board according to an embodiment.
FIG. 2 is a bottom view of a flexible circuit board according to an embodiment.
FIG. 3 is an enlarged view of region A of FIG. 1.
FIG. 4 is an enlarged view of region B of FIG. 1.
FIG. 5 is an enlarged view of region C of FIG. 2.
FIG. 6 is an enlarged view of region D of FIG. 2.
FIG. 7 is an enlarged view of region E of FIG. 1.
FIG. 8 is an enlarged view of region F of FIG. 1.
FIG. 9 is an enlarged view of region G of FIG. 1.
FIG. 10 is a drawing for explaining a COF module according to an embodiment.
FIG. 11 and FIG. 12 are cross-sectional views taken along region A-A' of FIG. 3.
FIG. 13 is a top view of a flexible circuit board according to another embodiment.
FIG. 14 is a bottom view of a flexible circuit board according to another embodiment.
FIG. 15 is an enlarged view of region A of FIG. 13.
FIG. 16 is an enlarged view of region B of FIG. 14.
FIG. 17 is an enlarged view of region C of FIG. 13.
FIG. 18 is an enlarged view of region D of FIG. 14.
FIG. 19 is a cross-sectional view taken along region B-B' of FIG. 17.
FIG. 20 is another enlarged view of region C of FIG. 13.
FIG. 21 is another enlarged view of region C of FIG. 13.
FIG. 22 is another enlarged view of region C of FIG. 13.
FIG. 23 is another enlarged view of region C of FIG. 13.
FIG. 24 is a drawing for explaining a connection of a COF module and other members according to an embodiment.
FIGS. 25 to 27 are drawings regarding an electronic device including a flexible circuit board according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

In addition, in a following description, a first direction 1D may be defined in a width direction of the flexible circuit board, and a second direction 2D may be defined in a length direction of the flexible circuit board.

Hereinafter, a flexible circuit board, a COF module, and an electronic device including the same according to an embodiment will be described with reference to the drawings.

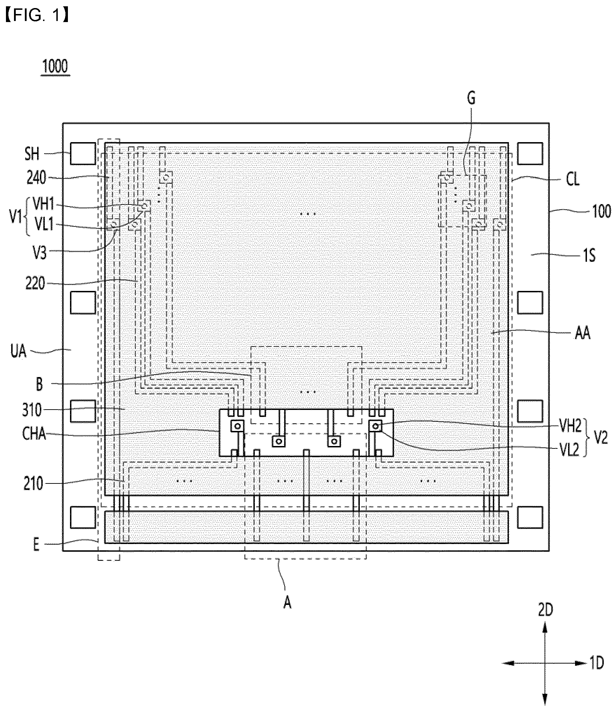

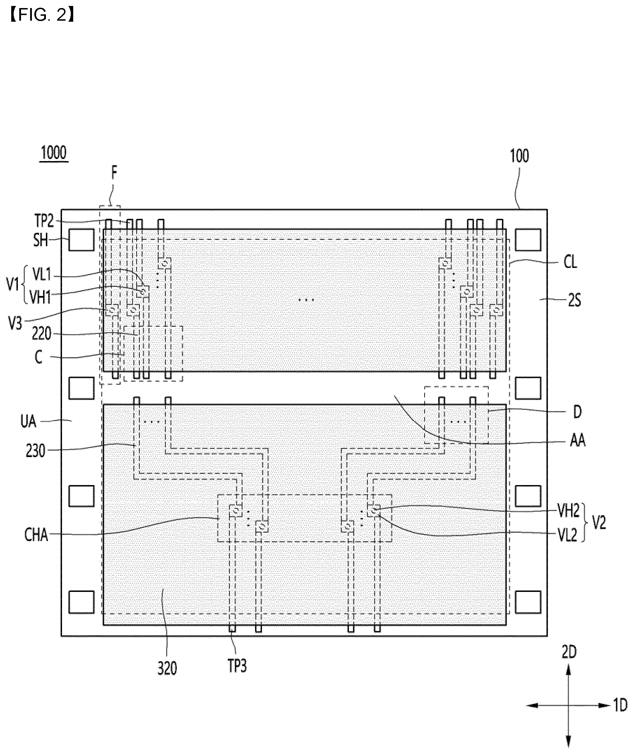

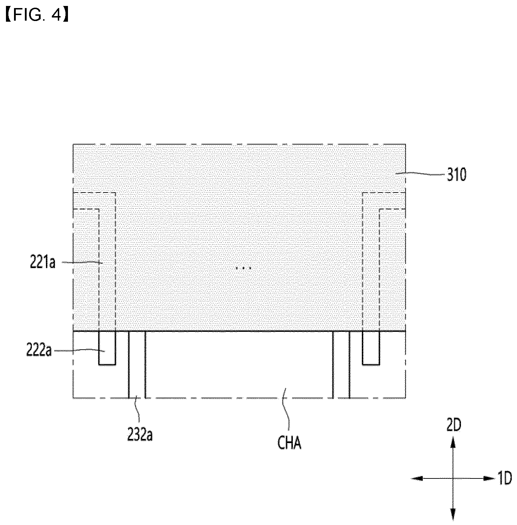

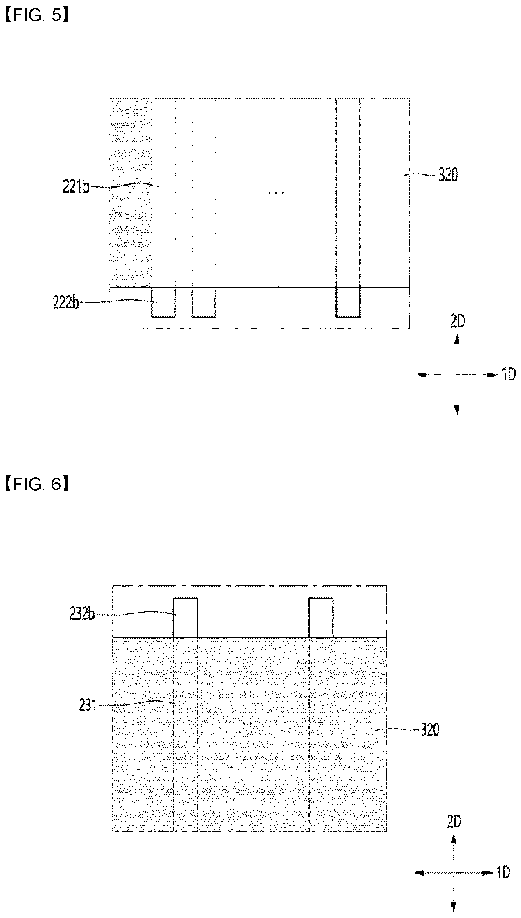

Referring to FIGS. 1 to 6, the flexible circuit board 1000 includes a substrate 100, a circuit pattern, and a protective layer.

The substrate 100 includes a first surface 1S and a second surface 2S opposite to the first surface 1S. The circuit pattern and the protective layer are disposed on the first surface 1S and the second surface 2S.

The substrate 100 includes a cutting line CL. The flexible circuit board 1000 is cut along the cutting line CL. For example, after the circuit pattern, the protective layer, and the chip are disposed on the substrate 100, the substrate 100 can be cut along the cutting line CL. Accordingly, the flexible circuit board 1000 is manufactured as a COF module 2000.

The substrate 100 can include an active region AA and an unactive region UA. The active region AA and the unactive region UA are separated by the cutting line CL. The active region AA is an inner region of the cutting line CL. The unactive region UA is an outer region of the cutting line CL.

The circuit pattern, the protective layer, and the chip are disposed on the active region AA. In addition, a dummy pattern DP and a sprocket hole SH are disposed on the unactive region UA. A strength of the substrate 100 is improved by a dummy pattern. By this, the flexible circuit board 1000 is prevented from being bent. The flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed inside the active region AA. The chip is disposed on the chip mounting region CHA. In addition, pad parts of the circuit pattern are disposed inside the chip mounting region CHA. In addition, the protective layer is not disposed on the chip mounting region CHA.

The substrate 100 may include a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board may be used in various electronic devices including a curved display device.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, the thickness of the flexible circuit board may increase. As a result, flexible characteristic of the flexible circuit board is reduced. In addition, if the thickness of the substrate 100 is less than 20 µm, the strength of the substrate is reduced. Therefore, when mounting the chip on the flexible circuit board, the substrate 100 may be damaged by heat and pressure transmitted to the substrate 100.

The circuit pattern and the protective layer are disposed on the substrate 100. For example, the circuit pattern and the protective layer may be disposed on the active region AA and the unactive region UA.

The circuit pattern may include a first circuit pattern 210, a second circuit pattern 220, a third circuit pattern 230, and a fourth circuit pattern 240. In addition, the protective layer may include a first protective layer 310 and a second protective layer 320.

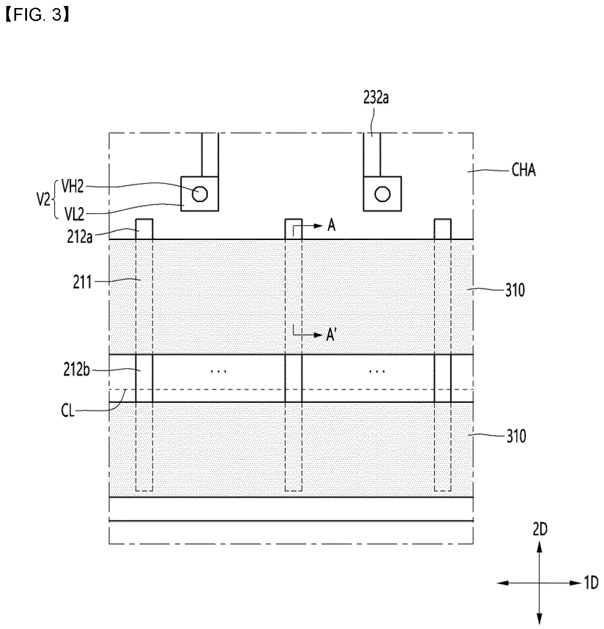

Referring to FIG. 1 and FIG. 3, the first circuit pattern 210 is disposed on the first surface 1S. The first circuit pattern 210 includes a first wiring part 211, a first pad part 212a, and a second pad part 212b. The first wiring part 211, the first pad part 212a, and the second pad part 212b may include a same material. The first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a terminal of a circuit board. Accordingly, the first circuit pattern 210 and the circuit board are connected.

The second pad part 212b may include a first test pad part. The first circuit pattern 210 is tested before connecting the circuit board and the second pad part 212b. For example, the first test pad part can be used to check whether the first circuit pattern is open or shorted.

The first wiring part 211 is disposed between the first pad part 212a and the second pad part 212b. The first wiring part 211 connects the first pad part 212a and the second pad part 212b. Accordingly, the chip and the circuit board are connected. Accordingly, a signal generated from the chip is transmitted to the circuit board.

The first protective layer 310 is disposed on the first circuit pattern 210. The first protective layer 310 is disposed on a region excluding the first pad part 212a and the second pad part 212b.

Referring to FIGS. 1, 2, 4, and 5, the second circuit pattern 220 is disposed on the first surface 1S and the second surface 2S. The second circuit pattern 220 includes the second wiring part 221a and 221b, the third pad part 222a, the fourth pad part 222b, and the first via V1. The second wiring part 221a and 221b, the third pad part 222a, and the fourth pad part 222b may include a same material. In addition, the second wiring part 221a and 221b, the third pad part 222a, and the fourth pad part 222b may be formed integrally.

The third pad part 222a is disposed on the first surface 1S. The third pad part 222a is disposed inside the chip mounting region CHA. Accordingly, the third pad part 222a is connected to a terminal of the chip. Accordingly, the second circuit pattern 220 and the chip are connected.

The fourth pad part 222b is disposed on the second surface 2S. The fourth pad part 222b is connected to a terminal of the display panel. Accordingly, the second circuit pattern 220 and the display panel are connected.

The second wiring part includes a second-first wiring part 221a and a second-second wiring part 221b. The second-first wiring part 221a is disposed on the first surface 1S. The second-second wiring part 221b is disposed on the second surface 2S. The second wiring part connects the third pad part 222a and the fourth pad part 222b. The second-first wiring part 221a is connected to the third pad part 222a. In addition, the second-second wiring part 221b is connected to the fourth pad part 222b.

Accordingly, the chip and the display panel are connected. Accordingly, a signal generated from the chip is transmitted to the display panel.

The first protective layer 310 and the second protective layer 320 are disposed on the second circuit pattern 220. The first protective layer 310 is disposed on the second circuit pattern 220 on the first surface 1S. The second protective layer 320 is disposed on the second circuit pattern 220 on the second surface 2S. The first protective layer 310 and the second protective layer 320 are disposed on a region excluding the third pad part 222a and the fourth pad part 222b.

The second-first wiring part 221a and the second-second wiring part 221b are connected. The second-first wiring part 221a and the second-second wiring part 221b are connected through the first via V1. The first via V1 penetrates the substrate 100. The first via V1 is disposed on the first surface 1S and the second surface 2S. The first via V1 on the first surface 1S and the first via V1 on the second surface 2S are disposed at corresponding positions.

The first via V1 includes a first via land VL1 and a first via hole VH1. The first via hole VH1 is formed inside the first via land VL1. A conductive material is disposed in the first via hole VH1. Accordingly, the second-first wiring part 221a and the second-second wiring part 221b are electrically connected.

The second circuit pattern 220 may include a second test pad part TP2. The second test pad part TP2 may be disposed on the second surface 2S. The second test pad part TP2 may be disposed on the unactive region UA. A second protective layer 320 is not disposed on the second test pad part TP2. The second test pad part TP2 may be connected to the second-second wiring part 221b. The second test pad part TP2 may be formed integrally with the second-second wiring part 221b.

The second circuit pattern 220 may be tested before connecting the display panel and the fourth pad part 222b. For example, the second test pad part TP2 can be used to check whether the second circuit pattern is open or shorted.

Referring to FIG. 1, FIG. 2, FIG. 3 and FIG. 6, the third circuit pattern 230 is disposed on the first surface 1S and the second surface 2S. The third circuit pattern 230 includes a third wiring part 231, a fifth pad part 232a, a sixth pad part 232b and a second via V2. The third wiring part 231, the fifth pad part 232a and the sixth pad part 232b may include a same material. The third wiring part 231, the fifth pad part 232a and the sixth pad part 232b may be formed integrally.

The fifth pad part 232a is disposed on the first surface 1S. The fifth pad part 232a is disposed inside the chip mounting region CHA. Accordingly, the fifth pad part 232a is connected to a terminal of the chip. Accordingly, the third circuit pattern 230 and the chip are connected.

The sixth pad part 232b is disposed on the second surface 2S. The sixth pad part 232b is connected to the terminal of the display panel. Accordingly, the third circuit pattern 230 and the display panel are connected.

The third wiring part 231 connects the fifth pad part 232a and the sixth pad part 232b. Accordingly, the chip and the display panel are connected. Accordingly, a signal generated from the chip is transmitted to the display panel.

The second protective layer 320 is disposed on the third circuit pattern 230. The second protective layer 320 is disposed on the third circuit pattern 230 on the second surface 2S. The second protective layer 320 is disposed on a region excluding the fifth pad part 232a and the sixth pad part 232b.

The fifth pad part 232a and the third wiring part 231 are connected. The fifth pad part 232a and the third wiring part 231 are connected through the second via V2. The second via V2 is disposed on the first surface 1S and the second surface 2S. The second via penetrates the substrate 100. The second via V2 on the first surface 1S and the second via V2 on the second surface 2S are disposed at corresponding positions.

The second via V2 includes a second via land VL2 and a second via hole VH2. The second via hole VH2 is formed inside the second via land VL2. A conductive material is disposed in the second via hole VH2. Accordingly, the fifth pad part 232a and the third wiring part 231 are electrically connected.

The third circuit pattern 230 may include a third test pad part TP3. The third test pad part TP3 may be disposed on the second surface 2S. The third test pad part TP3 may be disposed on the unactive region UA. The second protective layer 320 is not disposed on the third test pad part TP3. The third test pad part TP3 can be connected to the third wiring part 231. The third test pad part TP3 can be formed integrally with the third wiring part 231.

Before connecting the display panel and the sixth pad part 232b, the third circuit pattern 230 can be tested. For example, the third test pad part TP3 can be used to check whether the third circuit pattern is open or shorted.

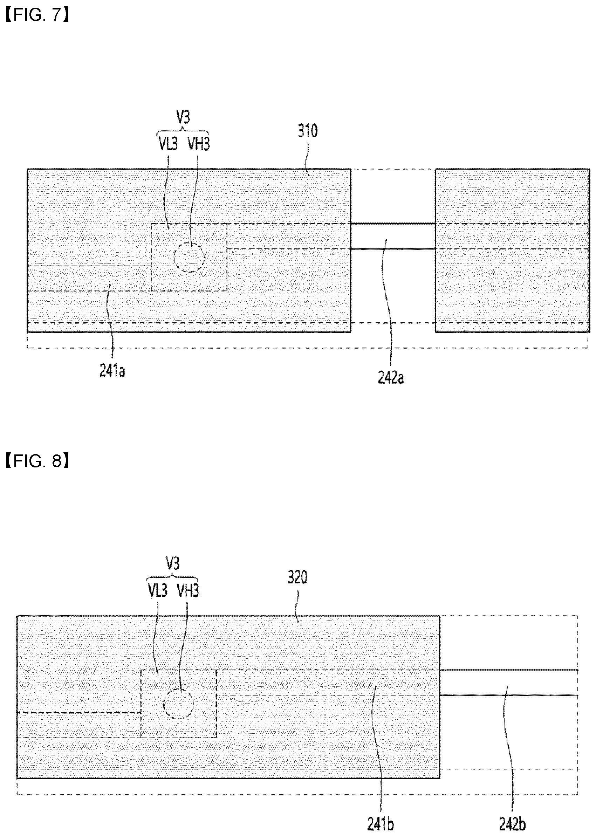

Referring to FIG. 1, FIG. 7, and FIG. 8, the fourth circuit pattern 240 is disposed on the first surface 1S and the second surface 2S. The fourth circuit pattern 240 includes a fourth wiring part 241a and 241b, a seventh pad part 242a, an eighth pad part 242b, and a third via V3. The fourth wiring part 241a and 241b, the seventh pad part 242a, and the eighth pad part 242b may include a same material. In addition, the fourth wiring part 241a and 241b, the seventh pad part 242a, and the eighth pad part 242b may be formed integrally.

The seventh pad part 242a is disposed on the first surface 1S. The seventh pad part 242a is disposed adjacent to the first pad part 212a. The seventh pad part 242a is connected to a terminal of the circuit board. As a result, the fourth circuit pattern 220 and the circuit board are connected.

The eighth pad part 242b is disposed on the second surface 2S. The eighth pad part 242b is connected to the terminal of the display panel. Accordingly, the fourth circuit pattern 240 and the display panel are connected.

The fourth wiring part includes a fourth-first wiring part 241a and a fourth-second wiring part 241b. The fourth-first wiring part 241a is disposed on the first surface 1S. The fourth-second wiring part 241b is disposed on the second surface 2S. The fourth wiring part connects the seventh pad part 242a and the eighth pad part 242b. The fourth-first wiring part 241a is connected to the seventh pad part 242a. The fourth-second wiring part 241b is connected to the eighth pad part 242b.

Accordingly, the circuit board and the display panel are connected. Therefore, the circuit board and the display panel can exchange signals with each other.

The first protective layer 310 and the second protective layer 320 are disposed on the fourth circuit pattern 240. The first protective layer 310 is disposed on the fourth circuit pattern 240 on the first surface 1S. The second protective layer 320 is disposed on the fourth circuit pattern 240 on the second surface 2S. The first protective layer 310 and the second protective layer 320 are disposed on a region excluding the seventh pad part 242a and the eighth pad part 242b.

The fourth-first wiring part 241a and the fourth-second wiring part 241b are connected. The fourth-first wiring part 241a and the fourth-second wiring part 241b are connected through the third via V3. The third via V3 is disposed on the first surface 1S and the second surface 2S. The third via V3 penetrates the substrate 100. The third via V3 on the first surface 1S and the third via V3 on the second surface 2S are disposed at corresponding positions.

The third via V3 includes a third via land VL3 and a third via hole VH3. The third via hole VH3 is formed inside the third via land VL3. A conductive material is disposed in the third via hole VH3. Accordingly, the fourth-first wiring part 241a and the fourth-second wiring part 241b are electrically connected.

The circuit pattern 210, 220, 230, and 240 may include a metal material having excellent electrical conductivity. In detail, the circuit pattern 210, 220, 230, and 240 may include copper (Cu). However, the embodiment is not limited thereto. The circuit pattern 210, 220, 230, and 240 may include at least one metal among copper (Cu), aluminum (Al), chromium (Cr), nickel (Ni), silver (Ag), molybdenum (Mo), gold (Au), titanium (Ti), and alloys thereof.

In addition, the first protective layer 310 and the second protective layer 320 may include a solder paste. The solder paste may include a thermosetting resin, a thermoplastic resin, a filler, a curing agent, or a curing accelerator.

As described above, the flexible circuit board 1000 includes a plurality of vias. The flexible circuit board 1000 includes the first via V1, the second via V2, and the third via V3.

The via land and the via hole may have a set size. The via lands may have a set distance. The via land and the wiring part may have a set distance. Accordingly, the flexible circuit board may have improved reliability, alignment characteristics, and process efficiency.

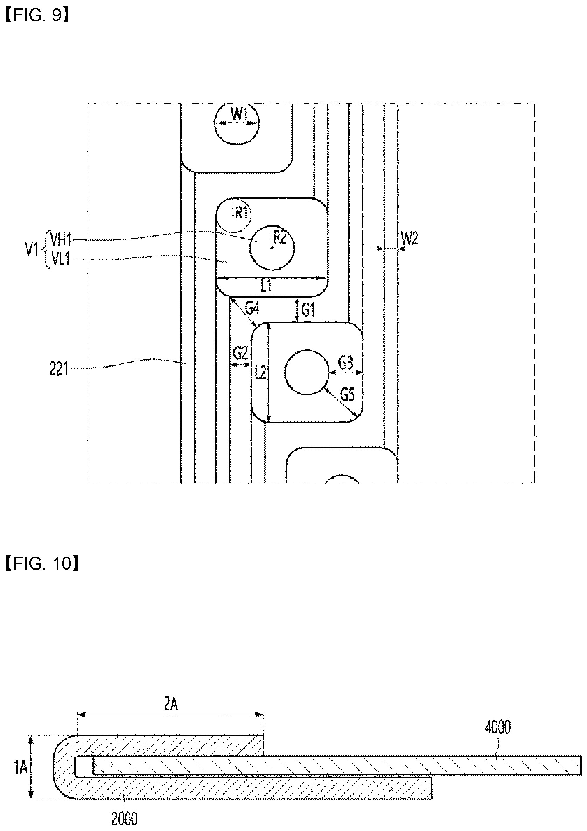

Referring to FIGS. 9 and 10, the vias and the wiring part of the flexible circuit board according to the embodiment will be described. In FIG. 9, the description will be based on the first via for convenience of explanation. The following description applies equally to the second via and the third via.

Referring to FIG. 9, the first via land VL1 has a first length L1 and a second length L2. The first length L1 is a length in the first direction D1. The second length L2 is a length in the second direction D2. The first length L1 and the second length L2 may be same or similar.

The first length L1 and the second length L2 have set sizes. For example, the first length L1 and the second length L2 may be 60 µm to 80 µm, 65 µm to 80 µm, or 67 µm to 75 µm.

If the first length L1 and the second length L2 are less than 60 µm, an area of the first via land VL1 is reduced. Accordingly, it becomes difficult to form the first via hole VL1 inside the first via land VL1. As a result, positions or sizes of the first via holes VH1 may change. Therefore, alignment characteristic of the first via hole VL1 decreases.

If the first length L1 and the second length L2 exceed 80 µm, the area of the first via land VL1 increases. Accordingly, a bezel region of the display panel connected to the COF module 2000 may increase.

Referring to FIG. 10, the COF module 2000 includes a first region 1A and a second region 2A. The first region 1A is a region where the vias V1, V2, and V3 are not disposed. The second region 2A is a region where the first via V1 and the third via V3 are disposed.

The COF module 2000 and the display panel 4000 are connected in the second region 2A. The COF module 2000 is bent in the first region 1A. That is, the COF module 2000 is bent in a region where the vias V1, V2, and V3 are not disposed. Accordingly, the second region 2A becomes a bezel region of the display panel 4000. Accordingly, when the area of the first via land VL1 increases, the bezel region of the display panel 4000 may increase. As a result, the active region of the display panel 4000 may decrease.

The first via hole VH1 has a first width W1. The first width W1 has a set size. For example, the first width W1 may be 20 µm to 30 µm, 22 µm to 28 µm, or 23 µm to 27 µm.

If the first width W1 is less than 20 µm, the alignment characteristic of the first via hole VH1 decreases. Accordingly, the connection characteristic of the first wiring part 221 on the first surface 1S and the second surface 2S decreases.

If the first width W1 exceeds 30 µm, it becomes difficult to form the first via hole VL1 inside the first via land VL1. Accordingly, the positions or sizes of the first via holes VH1 may vary. Therefore, the alignment characteristic of the first via hole VL1 is reduced.

A plurality of first via lands VL1 have a first spacing G1. The first via land VL1 and the first wiring part 221 have a second spacing G2. The first via hole VH1 and the first via land VL1 have a third spacing G3.

The first spacing G1, the second spacing G2, and the third spacing G3 may be different from the second width W2 of the first wiring part 221. For example, the first spacing G1, the second spacing G2, and the third spacing G3 may be larger than the second width W2.

For example, the first spacing G1 may be 1.1 times, 1.5 times, 2 times, 2.5 times, or 3 times or more of the second width W2. For example, the first spacing G1 may be more than more than 1 time and less than or equal to 5 times the second width W2. Since the first spacing G1 is set within the above range, a sufficient distance between the first via lands VL1 can be secured. Accordingly, adjacent first via lands VL1 are prevented from being connected during a process.

The second spacing G2 may be 1.1 times, 1.5 times, 2 times or more of the second width W2. For example, the second spacing G2 may be more than 1 time and less than or equal to 3 times the second width W2. Since the second spacing G2 is set to the above range, a sufficient distance between the first wiring parts 221 can be secured. Accordingly, adjacent first wiring parts 221 are prevented from being connected during the process.

The third spacing G3 may be 1.1 times, 1.5 times, 2 times, 2.5 times or 3 times or more of the second width W2. For example, the third spacing G3 may be more than 1 time and less than or equal to 5 times the second width W2. Since the third spacing G3 is set to the above range, the first via hole VH1 can be formed with a sufficient area. Thereby, the alignment characteristic of the first via hole VH1 is improved. In addition, the first via hole VH1 can be easily formed.

The first spacing G1 and the second spacing G2 can be different. In detail, the first spacing G1 can be larger than the second spacing G2. For example, the first spacing G1 can be more than 1 time the second spacing G2. In detail, the first spacing G1 can be 1.1 times, 1.5 times, 2 times, or 3 times or more the second spacing G2. For example, the first spacing G1 may be 1.1 to 5 times the second spacing G2.

For example, the first spacing G1 may be 12 µm or more. In detail, the first spacing G1 may be 12 µm to 30 µm, 13 µm to 25 µm, or 14 µm to 20 µm.

In addition, the second spacing G2 may be less than 12 µm. In detail, the second spacing G2 may be 3 µm to 11 µm, or 5 µm to 10 µm.

Since the first spacing G1 is set to the above range, the process efficiency of the first via land VL1 may be improved. The first via land VL1 is disposed with a larger area than the first wiring part 221.

For example, when forming the first via land VL1, the first via land VL1 is plated with a larger area than the first wiring part 221. Therefore, a DFR (Dry film resist) pattern between the first via land VL1 may be damaged during the plating process. As a result, the process efficiency of the first via land VL1 may be reduced.

Therefore, the first spacing G1 is formed with a sufficient size. Accordingly, the process efficiency of the flexible circuit board 1000 is improved.

The first via land VL1 includes a plurality of corner portions. The corner portions may have curved surfaces. The first via land VL1 includes at least one curved surface having a first radius of curvature R1. For example, the corner portions may include one or two corner portions connected to the first wiring part 221. In addition, the corner portion may include two or three corner portions that are not connected to the first wiring part 221. At least one corner portion that is not connected to the first wiring part 221 includes at least one curved surface. In addition, the curved surface has a first radius of curvature R1.

Thereby, a region in which the spacing between the first via lands VL1 is different is formed. In addition, a region in which the spacing between the first via land VL1 and the first wiring part 221 is different is formed. That is, the first spacing G1 is increased at the corner portion of the first via land VL1. In addition, the second spacing G2 is increased at the corner portion of the first via land VL1.

In detail, the first via lands VL1 adjacent to the corner portion have a fourth distance G4. In addition, the first via land VL1 and the first wiring part adjacent to the corner have a fourth distance G4. The fourth distance G4 may be greater than the first distance G1 and the second distance G2.

Therefore, the corner portion can be easily patterned. That is, the first spacing G1 and the second spacing G2 become larger at the corner portion where a patterning direction is different. Accordingly, the adjacent first via lands VL1 are prevented from being connected during the process. In addition, the first via land VL1 and the first wiring part 221 are prevented from being connected.

The first via hole VH1 is formed in a circular shape having a second radius of curvature R2.

The first radius of curvature R1 and the second radius of curvature R2 may be different. In detail, the first radius of curvature R1 may be larger than the second radius of curvature R2. That is, the curvature of the corner portion is smaller than the curvature of the first via hole VH1. For example, the first radius of curvature R1 may be 30 µm or less. In detail, the first radius of curvature R1 may be 1 µm to 30 µm, 5 µm to 25 µm, or 10 µm to 20 µm.

In addition, the first via hole VH1 and the corner portion are spaced apart by a fifth spacing G5.

The fourth spacing G4 and the fifth spacing G5 may be different. In detail, the fifth spacing G5 may be larger than the fourth spacing G4.

In addition, the third spacing G3 and the fifth spacing G5 may be different. In detail, the fifth spacing G5 may be larger than the third spacing G3.

Therefore, since a process of aligning the via becomes easy, the reliability of the flexible circuit board is improved.

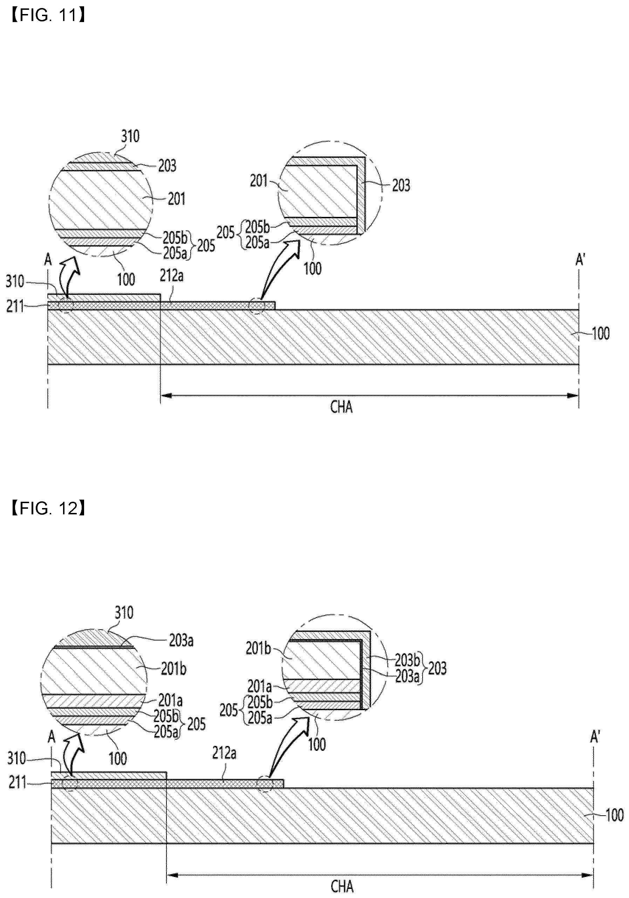

FIGS. 11 and 12 are drawings for explaining a layer structure of the circuit pattern. FIGS. 9 and 10 explain the first circuit pattern as an example.

Referring to FIG. 11, the first circuit pattern is formed in multiple layers. In detail, the first wiring part 211, the first pad part 212a, and the second pad part 212b include a buffer layer 205, a metal layer 201, and a bonding layer 203.

The buffer layer 205 may include multiple layers. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the first circuit pattern. For example, the second buffer layer 205b may include chromium (Cr).

The buffer layer 205 may have a thin film thickness in nanometer units. For example, the buffer layer 205 may have a thickness of 20 nm or less.

An adhesion between the substrate 100 and the first circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using the buffer layer as a seed layer. That is, the metal layer 201 may be a plating layer.

A thickness of the metal layer 201 may be 10 µm to 30 µm.

The bonding layer 203 is disposed on the metal layer 201.

The bonding layer 203 is disposed on a side surface and an upper surface of the metal layer 201. For example, the bonding layer 203 may be disposed while surrounding the metal layer 201.

The bonding layer 203 includes a metal. For example, the bonding layer 203 may include tin (Sn).

A thickness of the bonding layer 203 may be 0.3 µm to 0.7 µm. A tin content may increase as it extends from a lower surface of the bonding layer 203 toward of upper surface of the bonding layer 203.

That is, the bonding layer 203 is in contact with the metal layer 201. Therefore, a tin content increases as it extends from the lower surface of the bonding layer 203 toward the upper surface of the bonding layer 203. In addition, a copper content decreases as it extends from the lower surface of the bonding layer 203 toward the upper surface of the bonding layer 203.

Accordingly, pure tin may remain in a thickness range of 0.1 µm to 0.3 µm from the upper surface of the bonding layer 203.

The pad part may be easily bonded to the terminal of the chip, the circuit board, and the display panel by the bonding layer 203. For example, when heat and pressure are applied to the pad part, an upper surface of the bonding layer melts. Pure tin remains on the upper surface of the bonding layer. Therefore, the pad part is easily bonded to the terminals of the chip, the circuit board, and the display panel.

Referring to FIG. 12, the metal layer 201 layer may include a first metal layer 201a and a second metal layer 201b. The first metal layer 201a is disposed on the buffer layer 205. The second metal layer 201b is disposed on the first metal layer 201a.

A thickness of the first metal layer 201a may be smaller than a thickness of the second metal layer 201b.

For example, the thickness of the first metal layer 201a may be 0.7 µm to 2 µm, and the thickness of the second metal layer 201b may be 10 µm to 25 µm.

The first metal layer 201a and the second metal layer 201b may include a same metal material. For example, the first metal layer 201a and the second metal layer 201b may include copper (Cu).

The first metal layer 201a and the second metal layer 201b may be formed by a plating process. For example, the first metal layer 201a is thinly formed on the buffer layer 205. Then, the second metal layer 201b may be formed using the first metal layer 201a as a seed layer.

In addition, the bonding layer 203 may include a first bonding layer 203a and a second bonding layer 203b.

The first bonding layer 203a is disposed on the metal layer 201. In detail, the first bonding layer 203a is disposed on the first wiring part 211, the first pad part 212a, and the second pad part 212b.

The second bonding layer 203b is disposed on the first bonding layer 203a. In detail, the second bonding layer 203b is disposed on the first pad part 212a and the second pad part 212b.

Therefore, the first wiring part 211 includes the buffer layer 205, the metal layer 201, and the first bonding layer 203a. In addition, the first pad part 212a and the second pad part 212b include the buffer layer 205, the metal layer 201, the first bonding layer 203a, and the second bonding layer 203b.

Therefore, a layer structure of the first wiring part 211 is different from layer structures of the first pad part 212a and the second pad part 212b.

The first bonding layer 203a and the second bonding layer 203b include a metal. In detail, the first bonding layer 203a and the second bonding layer 203b may include tin (Sn).

The first bonding layer 203a and the second bonding layer 203b are disposed with different thicknesses. In detail, a thickness of the second bonding layer 203b is greater than a thickness of the first bonding layer 203a.

For example, the first bonding layer 203a has a thickness of 0.02 µm to 0.06 µm. In addition, the second bonding layer 203b has a thickness of 0.2 µm to 0.6 µm.

Therefore, the thickness of the first wiring part 211 becomes thin. Therefore, when the flexible circuit board is bent, cracks in the first wiring part 211 can be prevented.

A thickness of the first circuit pattern may be 2 µm to 25 µm. In detail, the thickness of the first circuit pattern may be 5 µm to 20 µm. In detail, the thickness of the first circuit pattern may be 7 µm to 15 µm.

If the thickness of the first circuit pattern is less than 2µm, the resistance of the first circuit pattern may increase. If the thickness of the first circuit pattern exceeds 25µm, it becomes difficult to implement a fine pattern.

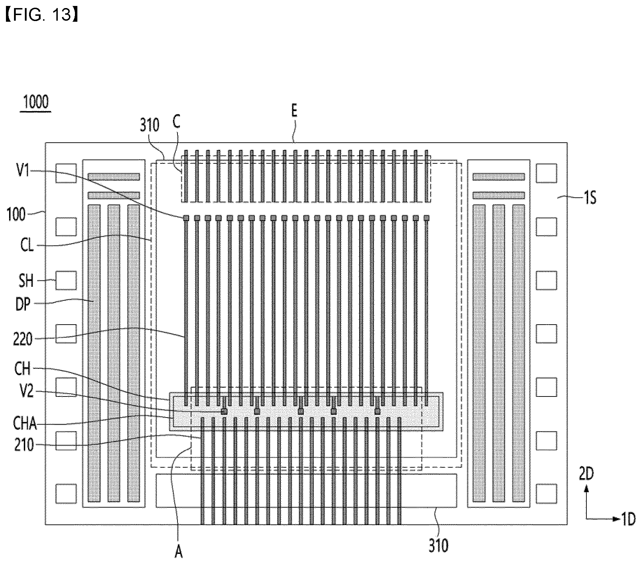

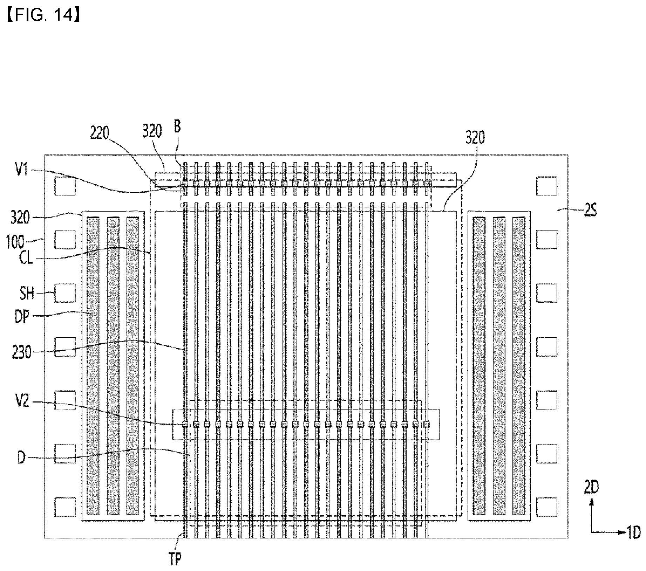

Hereinafter, a flexible circuit board according to another embodiment will be described with reference to FIGS. 13 to 23. Descriptions identical or similar to those of the flexible circuit board according to the previously described embodiment will be omitted.

Referring to FIGS. 13 to 19, the flexible circuit board 1000 includes a substrate 100, a circuit pattern, and a protective layer 310 and 320.

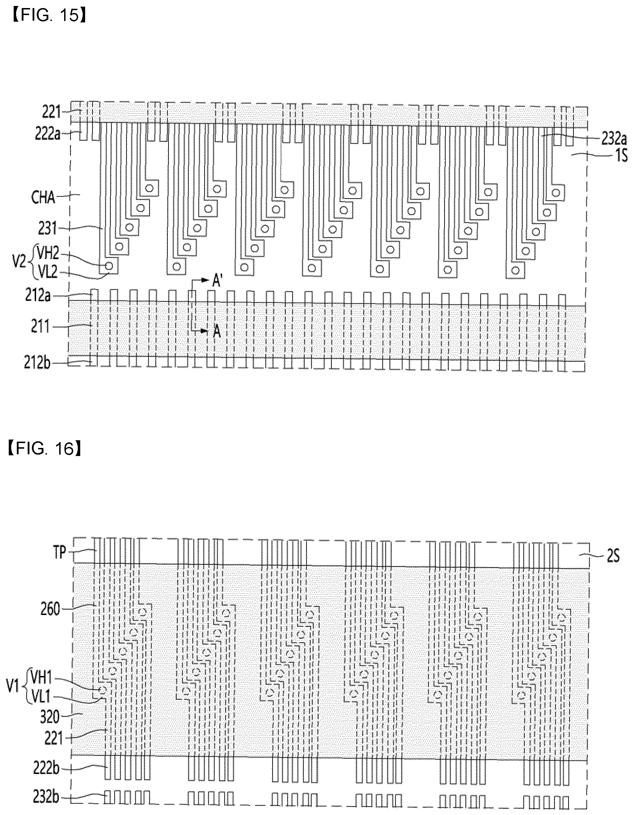

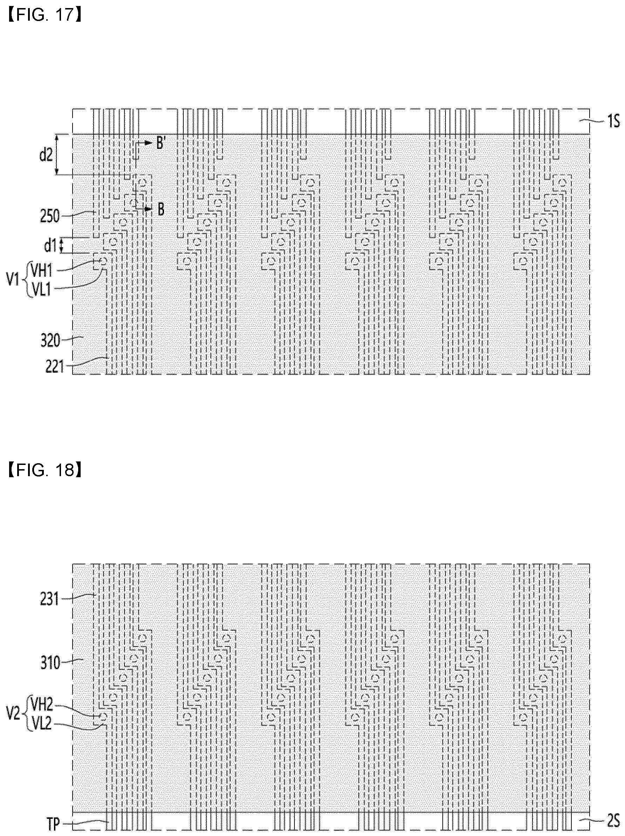

Referring to FIGS. 16 and 17, metal patterns 250 and 260 are disposed on the first surface 1S and the second surface 2S, respectively. The metal patterns 250 and 260 are disposed adjacent to the first via V1. The metal patterns 250 and 260 are disposed between the first via V1 and the end (E) of the substrate 100. The metal patterns 250 and 260 are disposed between the first via V1 and the cutting line CL.

Referring to FIG. 16, the metal pattern 260 is disposed on the second surface 2S. The metal pattern 260 is connected to the first via V1. Also, referring to FIG. 18, the metal pattern 250 is disposed on the first surface 1S. The metal pattern 250 is spaced apart from the first via V1.

The metal pattern 260 may be a test pad. The metal pattern 260 may test the short and short circuit of the second circuit pattern 220.

The metal pattern 250 may be a dummy pattern. When the metal pattern 250 and the first via V1 are connected, a signal transmitted from the chip CH moves to the dummy pattern. Therefore, signal loss may occur. Accordingly, the metal pattern 250 is spaced apart from the first via V1.

The metal pattern 250 is spaced apart from the first via V1 by a first spacing D1.

The first spacing d1 may be equal to or greater than a line width of the second wiring part 221 and equal to or less than a width of the first via land VL1 in the first direction. If the first spacing d1 is less than the line width of the second wiring part 221, the metal pattern 250 and the first via V1 can come into contact. Accordingly, the first via V1 and the metal pattern 250 can be electrically connected. Accordingly, a signal generated from the chip is transmitted to the metal pattern 250, so that signal loss and power loss may occur.

If the first spacing d1 exceeds the width of the first via land VL1, an area where the metal pattern 250 can be formed becomes narrow. Accordingly, an area of the metal pattern 250 may be reduced. The metal pattern 250 may be a dummy pattern spaced apart from the second circuit pattern 220. Accordingly, if an area of the metal pattern 250 is reduced, a strength of the flexible circuit board may be reduced. By this, the flexible circuit board can be bent in one direction.

In another embodiment, the flexible circuit board is spaced apart from the second wiring part 221 and the metal pattern 250. Accordingly, when a signal transmitted from the chip moves to the display panel, the signal can be prevented from moving in a direction of the metal pattern. Accordingly, the signal loss of the flexible circuit board is reduced, and the driving power is reduced.

In addition, since the second wiring part 221 and the metal pattern 250 are spaced apart, the reliability of the flexible circuit board is improved. The metal pattern 250 can extend to the cutting line CL. Accordingly, the metal pattern 250 can be exposed to an outside. Accordingly, corrosion may occur in the metal pattern 250.

Since the second wiring part 221 is spaced apart from the metal pattern 250, corrosion of the metal pattern 250 can be prevented from extending to the second wiring part 221. Accordingly, corrosion of the second circuit pattern 220 is prevented. Accordingly, reduction in electrical characteristics of the flexible circuit board can be prevented, and reliability can be improved.

In addition, since the metal pattern is disposed between the second circuit pattern and the end of the substrate, bending of the flexible circuit board is prevented. Since the metal pattern is disposed spaced apart from the second circuit pattern, it is not connected to the chip. Since the metal pattern is disposed between the second circuit pattern and the end of the substrate, the strength of the flexible circuit board is improved. That is, the metal pattern may be a dummy pattern. Since the strength of the flexible circuit board is improved by the metal pattern, bending of the flexible circuit board is prevented.

Referring to FIG. 17, the second circuit pattern 220 on the first surface 1S is spaced apart from the cutting line CL. The flexible circuit board is cut along the cutting line CL. In addition, the second circuit pattern is spaced apart from the end of the substrate.

A minimum distance between the first via V1 and the cutting line CL is defined as a second spacing d2. The second spacing d2 may be 1 to 4 times, 1.5 to 3.5 times, or 2 to 3 times a width of the first via land VL1 in the second direction.

If the second spacing d2 is less than 1 time the width of the first via land V1, a byproduct generated when cutting the substrate along the cutting line CL may be transferred to the second circuit pattern 220. Accordingly, the adjacent first via portions V1 may be short-circuited by the byproduct. Alternatively, the conductivity of the second circuit pattern may be reduced.

In addition, if the second spacing d2 is more than four times the width of the first via land VL1, a bezel region of the flexible circuit board increases. Accordingly, the size of the flexible circuit board increases.

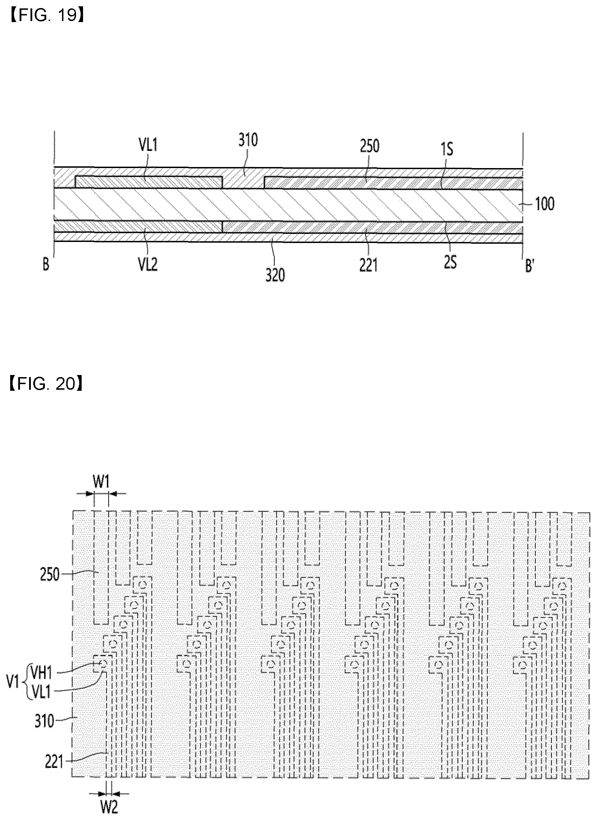

Referring to FIG. 19, the second circuit pattern 220 on the first surface 1S may be surrounded by the first protective layer 310. In detail, the first via V1 may be surrounded by the first protective layer 310.

A first protective layer 310 is disposed between the metal pattern 250 and the first via V1. In detail, the metal pattern 250 and the first via V1 are spaced apart, and the first protective layer 310 is disposed on a spaced region.

Therefore, even if the size of the first spacing d1 decreases during the process, the second circuit pattern 220 and the metal pattern 250 can be prevented from coming into contact. In addition, since the first protective layer 310 is disposed between the metal pattern 250 and the first via V1, the corrosion of the metal pattern 250 can be prevented from being transferred to the second circuit pattern 220.

In addition, since the metal pattern 250 and the first via V1 are spaced apart, a process of forming the first protective layer 310 becomes easy. The first protective layer 310 can be formed of a liquid material. Accordingly, the liquid material can move to a separation region between the metal pattern 250 and the first via part V1. Accordingly, a movement path of a material forming the first protective layer increases. Accordingly, a process time for forming the first protective layer is reduced, and a thickness of the first protective layer becomes uniform.

Referring to FIG. 20, line widths of the metal pattern 250 and the second wiring part 221 may be different. For example, a line width W1 of the metal pattern 250 may be larger than a line width W2 of the second wiring part 221. For example, the line width W1 of the metal pattern 250 may be 2 to 20 times, 3 to 15 times, or 5 to 10 times the line width W2 of the second wiring part 221. Alternatively, the line width W1 of the metal pattern 250 may be 1 to 3 times, 1.5 to 2.5 times, or 1.7 to 2.3 times the width of the first direction of the first via land VL1.

Accordingly, an area of the metal pattern disposed on the flexible circuit board increases. Accordingly, the strength of the flexible circuit board is improved, and the flexible circuit board can be prevented from bending.

In addition, it is possible to prevent the process time for forming the metal pattern 250 from being excessively increased. Therefore, the process efficiency can be improved.

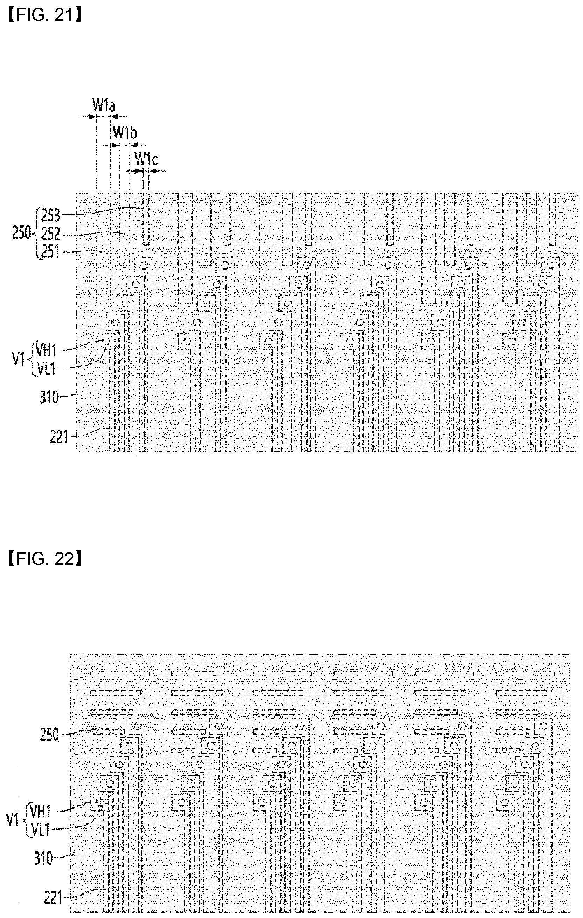

Referring to FIG. 21, the metal pattern 250 includes a plurality of metal patterns. The plurality of metal patterns may have different line widths. For example, the metal pattern 250 may include a first metal pattern 251, a second metal pattern 252, and a third metal pattern 253. The line widths of the first metal pattern 251, the second metal pattern 252, and the third metal pattern 253 may be different.

For example, a line width W1a of the first metal pattern 251 may be larger than a line width W1b of the second metal pattern 252 and a line width W1c of the third metal pattern 253. In addition, the line width W1b of the second metal pattern 252 may be larger than the line width W1c of the third metal pattern 253.

In FIG. 21, the first metal pattern 251, the second metal pattern 252, and the third metal pattern 253 are illustrated as being regularly disposed, but the embodiment is not limited thereto.

The metal pattern 250 is disposed with various line widths at each location. Therefore, the reliability of the flexible circuit board is improved. In detail, the flexible circuit board may be bent in one direction due to the difference in the area of the patterns disposed on the first surface and the second surface. Therefore, considering the difference in the area of the patterns, the metal pattern is disposed with different widths at each location. Therefore, the flexible circuit board can be prevented from being bent.

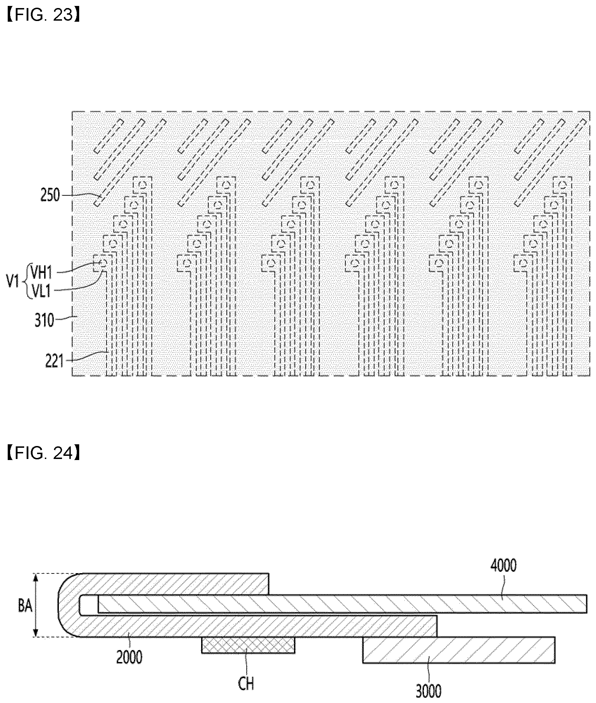

Referring to FIGS. 22 and 23, the metal pattern 250 and the second wiring part 221 may extend in different directions.

For example, referring to FIG. 22, the metal pattern 250 may extend in a first direction 1D. The second wiring part 221 may extend in a second direction 2D. In detail, the metal pattern 250 may extend in a direction perpendicular to the direction in which the second wiring part 221 extends.

Alternatively, referring to FIG. 23, the metal pattern 250 may extend in a diagonal direction between the first direction 1D and the second direction 2D. The second wiring part 221 may extend in the second direction 2D.

The metal pattern 250 may extend in various directions different from the direction in which the second wiring part 221 extends. Accordingly, even if the area of the bezel region of the flexible circuit board decreases, the metal pattern is disposed with a sufficient area. In detail, when the number of terminals of the display panel increases, the number of the second circuit patterns also increases. Accordingly, when the number of the first vias increases, the area where the metal pattern can be formed may become narrow. Therefore, the embodiment arranges the dummy pattern by extending it in various directions. Accordingly, even if the area of the bezel region decreases, the metal pattern can be disposed with a sufficient area.

The flexible circuit board according to the embodiment can form a COF module by mounting a chip CH on the chip mounting region CHA and cutting the cutting line CL.

The COF module 2000 is connected to the display panel 4000 and the circuit board 3000. Accordingly, a signal can be transmitted to the display panel 4000 and the circuit board 3000.

Referring to FIG. 24, one end of the COF module 2000 is connected to the display panel 4000. Another end of the COF module 2000 is connected to the circuit board 3000. For example, the display panel 4000 may be disposed on one surface of the COF module 2000. In addition, the circuit board 3000 may be disposed on another surface of the COF module 2000. However, the embodiment is not limited thereto. The display panel 4000 and the circuit board 3000 may be disposed on a same surface of the COF module 2000.

The COF module 2000 includes a flexible substrate. Therefore, it may have both a rigid form and a bent form between the display panel 3000 and the circuit board 4000. That is, the COF module 2000 may include a bending region BA.

The COF module 2000 may connect the display panel 4000 and the circuit board 3000 in a bent form. Therefore, the thickness of the electronic device may be reduced. In addition, the degree of design freedom may be improved. In addition, the wiring of the COF module 2000 may not be broken even in a bent form. Accordingly, the reliability of the electronic device including the COF module may be improved.

Since the COF module is flexible, it may be used in various electronic devices.

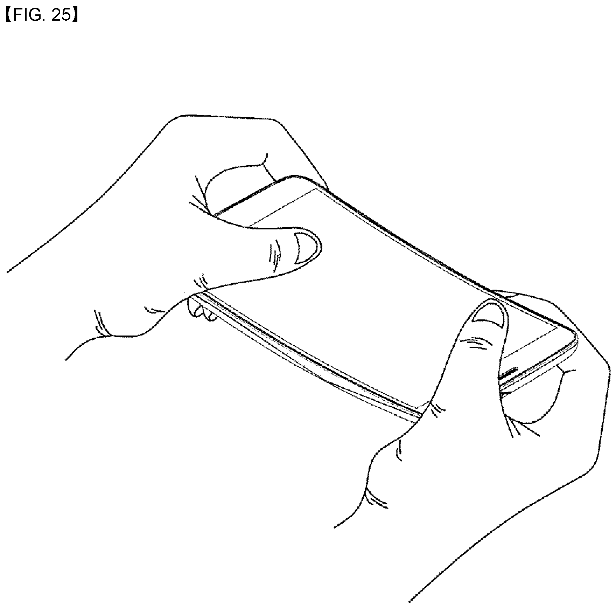

For example, referring to FIG. 25, the COF module may be applied to a flexible touch window that bends. Therefore, a touch device including the COF module may be a flexible touch device. Therefore, a user may bend or fold it by hand.

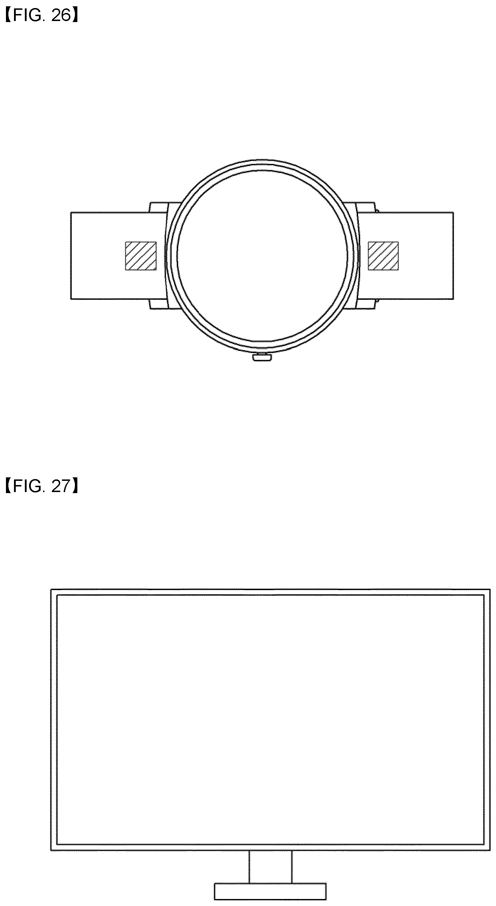

Referring to FIG. 26, the COF module can be applied to various wearable touch devices including a curved display. Accordingly, an electronic device including the COF module can be slimmed down or lightened.

Referring to FIG. 27, the COF module can be applied to various electronic devices having a display such as a TV, a monitor, and a laptop.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A flexible circuit board comprising:
a substrate including a first surface and a second surface opposite to the first surface;
a first circuit pattern disposed on the first surface;
a second circuit pattern disposed on the first surface and the second surface; and
a third circuit pattern disposed on the first surface and the second surface,
wherein the second circuit pattern includes a first via and a second wiring part,
wherein the third circuit pattern includes a second via and a third wiring part,
wherein the first via and the second via includes a via land and a via hole formed in the via land,
wherein at least one of the first via and the second via is defined as a first spacing between the via lands; a second spacing between the via land and the second wiring part or the third wiring part adjacent to the via land and a third spacing between a side surface of the via land and the via hole, and
wherein at least one of the first spacing, the second spacing and the third spacing is greater than a width of the wiring part.

2. The flexible circuit board of claim 1, wherein the first spacing is more than 1 time and less than or equal to 5 times the width of the wiring part.

3. The flexible circuit board of claim 1, wherein the second spacing is more than 1 time and less than or equal to 3 times the width of the wiring part.

4. The flexible circuit board of claim 1, wherein the third spacing is more than 1 time and less than or equal to 5 times the width of the wiring part.

5. The flexible circuit board of claim 1, wherein the first spacing and the second spacing are different.

6. The flexible circuit board of claim 5, wherein the first spacing is 1.1 to 5 times the second spacing.

7. The flexible circuit board of claim 5, wherein the first spacing is 12 µm to 30 µm, and
wherein the second spacing is 3 µm to 11 µm.

8. The flexible circuit board of claim 1, wherein at least one corner of the via land includes a curved surface having a first radius of curvature.

9. A COF module comprising:
a flexible circuit board according to any one of claims 1 to 8; and
a chip disposed in a chip mounting region of the flexible circuit board.

10. An electronic device comprising:
a COF module according to claim 9;
a circuit board connected to the first circuit pattern; and
a display panel connected to the second circuit pattern and the third circuit pattern.
